# EUROPEAN PATENT SPECIFICATION

(11) **EP 1 664 924 B1**
(45) Date of publication and mention of the grant of the patent: **02.05.2012**
(21) Application number: 04764051.1
(22) Date of filing: 12.08.2004
(51) Int. Cl.: G03F 1/74, H01J 37/305, C23F 4/00, H01L 21/768, H01L 21/3213

(54) **METHOD FOR HIGH-RESOLUTION ETCHING OF THIN LAYERS WITH ELECTRON BEAMS**
VERFAHREN ZUM HOCHAUFLÖSENDEN ÄTZEN DÜNNER SCHICHTEN MITTELS ELEKTRONENSTRAHLEN
PROCEDE DE GRAVURE AVEC UNE HAUTE RESOLUTION DE COUCHES MINCES AU MOYEN DE FAISCEAUX D' ELECTRONS

(30) Priority: 19.08.2003 DE 10338019
(43) Date of publication of application: 07.06.2006
(73) Proprietor: NaWoTec GmbH, 64380 Rossdorf (DE)
(72) Inventor: KOOPS, Hans, W., P., 64372 Ober-Ramstadt (DE); EDINGER, Klaus, 64646 Heppenheim (DE); BABIN, Sergey, Castro Valley, CA 94546 (US); HOFMANN, Thorsten, 63110 Rodgau (DE); SPIES, Maria, 55130 Mainz (DE)
(74) Representative: Heselberger, Johannes
(86) International application number: PCT/EP2004/009049
(87) International publication number: WO 2005/017949

(56) References cited:
- DE-A1- 3 042 650
- US-A- 4 239 954
- US-A- 6 042 738
- JIANHUA WANG ET AL: "Etching characteristics of chromium thin films by an electron beam induced-surface reaction" SEMICONDUCTOR SCIENCE AND TECHNOLOGY IOP PUBLISHING UK, vol. 18, no. 4, 10 February 2003 (2003-02-10), pages 199-205, XP002316580 ISSN: 0268-1242
- PATENT ABSTRACTS OF JAPAN vol. 007, no. 095 (C-163), 23 August 1983 (1983-08-23) & JP 58 022382 A (MITSUBISHI DENKI KK), 9 February 1983 (1983-02-09)
- P.L. HAWKES ET AL: "the preparation of microcircuit stencils and patterns by photomechanics and electron beam machining" MICROELCTRONICS AND RELIABILITY, vol. 4, no. 1, 1965, pages 65-79, XP008046017 UK
- PATENT ABSTRACTS OF JAPAN vol. 1995, no. 04, 31 May 1995 (1995-05-31) & JP 07 011429 A (TOSHIBA CORP), 13 January 1995 (1995-01-13)

## Description

### 1. Technical field

The present invention relates to methods for high resolution processing of thin layers using electron beams, in particular layers in a mask for photolithography or in a semiconductor device.

### 2. The prior art

Semiconductor devices, such as processors or memory chips, are produced using photolithography. A photo-resist layer on a wafer out of a semiconductor material is exposed through a mask for the simultaneous creation of a plurality of microscopically fine structures which are subjected to further method steps to manufacture the electronic components of the device (transistors, capacitors etc.). In order to achieve ever increasing densities of integration within a semiconductor device, ultraviolet light with short wavelengths is now used for the exposure. The manufacture of suitable masks for this lithography method is extremely expensive.

If it is later found that a mask comprises an error, it is desirable to repair the mask. To this end, it is necessary to selectively remove or deposit metal layers, for example chromium layers which form the opaque sections of the mask, with a high spatial resolution. A similar problem arises if an already finished semiconductor device is to be modified (so-called "circuit editing") wherein the structure of the strip conductors of the device is modified with a high resolution. The metal layers to be processed are typically arranged within a composite of a metal / metal oxide / insulator.

One method known from the prior art is the processing using a focused ion beam. However, this causes inevitably the implantation of ions in the substrate, for example the quartz substrate of a mask for photolithography, which thereby changes its properties. This disadvantage of the ion beam technology is avoided if electron beams are used.¹
¹T. Liang, et al., "Progress in extreme ultraviolet mask repair using a focused ion beam", J. Vac. Sci. Technol. B 18(6), 3216 (2000), and
T. Liang, et al., "Evaluation of 157nm substrate damage during mask repair", 157nm Lithography Symposium, Dana Point, CA, May 2001.

In general it is also known to process metals using electron beams of high energy, for example for welding. However, if the diameter of the area covered by the electron beam is less than 2µ, the heat removing surface of the heated material is significantly greater than the area of the beam supplying the heat As a consequence, it was considered to be impossible until now at least for metals, due to their good thermal conductivity, to process them alone with electron beams with a resolution necessary for the above mentioned tasks.

A different method is the so-called electron beam induced etching (EBIE). It has been known for a long time that XeF₂ can be used as a spontaneous and activatable etching means for the electron beam induced etching of metals and metal oxides, here silicon.² The electron beam selectively breaks up the molecules of the etching gas and thereby allows a spatially resolved etching. For example the article *"*Etching characteristics of chromium thin films by an electron beam induced surface reaction" of P.E. Russel et al. (Semicond. Sci. Technol. 18 (2003) page 199 - 205) discloses the etching of thin chromium layers of a mask by the EBIE-method in the presence of XeF₂.
²J.W. Coburn and H.F. Winters, "Ion- and electron-assisted gas-surface chemistry- an important effect in plasma etching", J. Appl. Phys. Vol. 50(5), 3189 (1979).

The publication of Russel et al. teaches to use XeF₂ and high electron energies of 5 - 20 keV as well as comparatively high electron currents of 1.6 nA to obtain high yields of removal. However, it is reported that the high electron energy causes a loss of spatial resolution, when etching a chromium layer. Furthermore, the method disclosed by Russel et al. does not allow to etch any chromium layer. For example a chromium layer sputtered onto a silicon substrate could not be etched. The explanation for this failure was that metal contaminations in the deposited chromium layer impair the etching process.

In the discussion of the measurement results Russel et al. teach that the surface chemical process; which determines the etching rate, is the desorption of CrO₂F₂ or - as an alternative reaction product - CrOF₂ from the surface of the chromium layer (cf. page 204, centre of the left column). Oxygen, by contrast, which is to some extent always present in the residual gas of the vacuum chamber, is not considered by Russel et al. to be a relevant factor for the etching rate to be obtained.

At electron beam energies of 5 keV chromium oxide layers can be etched but not chromium film. The authors assume that the desorption of CrO₂F₂ an CrOF₂ influences the etch rate significantly.

US Patent 6,042,738 discloses a method for employing a gas-assisted focused ion beam etching system in the removal of an excess portion from a work-piece having an opaque film patterned on a substrate. The etching gas includes bromine or a bromine containing material and can also contain water vapor. The film includes chromium-based films and molybdenum silicide-based films. The substrate may be quartz or a variety of other materials.

JP 58022382 A describes the formation of a chromium metal pattern by etching a chromium metal film masked with a photo-resist pattern or an electron beam resist pattern by a mixed gas containing a halogen gas, carbon dioxide and helium.

Finally, it is for the repair of masks and the mentioned circuit editing not sufficient to only remove metal / metal oxide / insulating layers. Also the selective deposition of a metal layer is necessary. Only then it is possible to simply and reliably repair or modify photolithography masks and other metal / metal oxides / insulating layer systems. According to a first aspect, the present invention is therefore based on the problem to provide a method which allows to etch with a high resolution, a high yield and contour sharpness metal layers and / or metal oxide layers, for example Cr / CrO layers of any type independent from the substrate.

### 3. Summary of the invention

According to the present invention a method is provided for etching a metal layer, in particular a chromium layer, inside a vacuum chamber comprising the method steps of introducing fluorine containing a halogen compound into the vacuum chamber, directing an electron beam having an energy of < 5 Kev onto the area of the chromium layer to be etched and additionally introducing an oxygen containing compound into the vacuum chamber.

In particular the additional provision of an oxygen containing compound assures a high etching yield for the metal layer at low electron energies and avoids the deterioration of the resolution described in the prior art. Furthermore, it was observed that the method according to the invention also allows to etch sputtered or vapor deposited chromium layers. The etching reaction is exclusively initialized by the focused electron beam. There are no other energy transmitting mechanisms such as heating the sample or laser radiation.

The exact dosage of the fluorine containing halogen compound and the oxygen containing compound depends to a large extent on the geometry of the vacuum chamber, the pumping power of the used vacuum pumps as well as the geometric arrangement of the gas nozzles. In general the gas flow of the halogen compounds should be adjusted such that the partial pressure measured inside the chamber is in the range of 10⁻⁵ to 10⁻³ mbar. Due to the arrangement of the gas nozzles close to the substrate, this corresponds to a local gas pressure at the location of repair of approximately 10⁻⁴ to 10⁻¹ mbar. The ratio of local partial pressures defined in this manner between the halogen and the oxygen containing compound should be in the range of 1000:1 to 1:2, particularly preferred between 100:1 und 1:1 and most preferred essentially at 10:1.

In this context, it is to be noted that even at a low dosage of the oxygen containing compound its local partial pressure at the location of repair is still above the corresponding typical base pressure in the chamber which would be present if no oxygen containing compound was added. Concerning the sequence of dosage the fluorine containing halogen compound and the oxygen containing compound can be introduced into the vacuum chamber either sequentially or essentially simultaneously.

O₂, H₂O, or H₂O₂ or mixtures thereof are preferably used as oxygen containing compounds.

As already mentioned, the method according to the invention allows to use lower electron beam energies and lower currents. Preferably, the electron beam has a current of < 400 pA and particularly preferably of < 100 pA. The electron beam has an energy of < 5 keV, preferably of essentially 1 keV. The electron beam has preferably a current density of more than 1 A/cm², most preferred > 200 A/cm². Even at an electron energy of 1 keV, this can well be achieved by using the LEO Gemini lens of the company LEO Elektronenmikroskopie, GmbH and by using a cold or thermal field emission electron source.³
³H. Jaksch "Field emission SEM for true surface imaging and analysis", Materials World, October (1996),
and P. Gnauck "A new high resolution field emission SEM with variable pressure capabilities" Proc. EUREM 2000 BRNO, CZ.

Furthermore, the etching method of present invention relates to a method for the highly resolved manufacture of a metal layer and / or a metal oxide layer and / or an insulator comprising the steps of arranging a substrate inside a vacuum chamber, leading at least one anorganic, organic or metal organic precursor into the vacuum chamber, depositing the precursor onto the substrate and selectively irradiating the substrate with an electron beam for manufacturing a conducting metal layer from the deposited precursor, and / or selectively irradiating the substrate with an electron beam for manufacturing a non-conducting insulating layer from the deposited anorganic or organic precursor.

The metal organic precursor comprises preferably atoms of a metal with a low electric resistance to create conducting interconnections of a high quality with the method according to the invention.

The inorganic or organic precursor comprises groups of molecules of insulators in order to create insulators of a high quality with the method according to the invention.

The selective irradiation of the substrate causes preferably a localized heating to a temperature between 50°C and 100°C, particularly preferably between 70°C and 80°C, leading to a desorption of the organic compounds of the detraction products of the precursor and the unintended reaction products from the substrate.

The fact that a global heating of the substrate may cause an improvement of the resistance is prior art (H.W.P. Koops, C. Schössler, A. Kaya, M. Weber, "Conductive dots, wires and supertips for field electron emitters produced by electronbeam induced deposition on samples having increased temperature" J. Vac. Sci. Technol. B14(6) (1996) 4105).

The method indicated here no longer requires the expensive heating table and, by far more important, thereby excludes the resulting drifts and instabilities of the process and the apparatus.

Further, this method can be advantageously used to control and to accelerate (temperature range from room temperature up to 150°C) the chemical reaction of metal etching or the deposition of insulators of high quality by the localized temperature increase. Alternatively, a delay is possible by significantly reducing the condensation of the precursor at temperatures close to or above 350°C.

Finally, the present invention relates according to a further aspect to a method for processing a photolithographic mask and / or the conducting strips of a semiconductor device comprising the steps of the highly resolved removal of a metal and / or metal oxide and / or an insulating layer with any of the above indicated methods, the steps of depositing a new metal layer with the above explained method and the optional or alternative step of the additional provision of a new insulating layer with the method explained above.

The combination of the etching method according to the invention for a highly resolved removal of undesired layers with the highly resolved deposition of a conducting metal layer and / or an insulating layer allows to remove many different defects of a photolithography mask. With respect to a semiconductor device a circuit editing is possible, i.e. the selective modification of the microscopically small electric structures by later selectively separating or interconnecting conducting strips of the device.

Further dependent claims are directed to further advantageous modifications of the present invention.

### 4. Short description of the drawing

In the following detailed description, presently preferred embodiments of the invention are described with reference to the drawing, wherein
- Fig. 1: shows a schematic presentation for performing the method according to the invention wherein a sample arranged within a vacuum chamber is processed by a focussed electron beam and wherein different reagents for reacting with the material arranged on the sample are supplied with at least two gas supply nozzles;
- Fig. 2: shows a schematic presentation for performing an alternative method , wherein a sample arranged within a vacuum chamber is processed exclusively by bombardment with a focused electron beam;
- Fig. 3: shows a schematic presentation for performing a method for a highly resolved deposition of a metal layer and / or an insulating layer ; and
- Figs. 4a-c: show schematically the sequence of steps when repairing a metal layer, for example of a photolithographic mask, wherein layer material is at first removed and subsequently new metal and / or insulator material is selectively deposited in the defect region. This is particularly used for EUV-masks⁴ and nano-imprint masks or stamps of the process "step and flash imprint lithography (S-FIL)⁵" but also for other imprint masks.
⁴P.B. Mirkarimi, D.G. Steams, S. L. Baker, J.W. Elmer, and D.W. Sweeney "Method for repairing Mo/Si-Multilayer thin-film phase defects in reticles for extreme ultraviolet lithography, Journal of Applied Physics Vol. 91, Number 1, 1. January 2002 pages 81- 89,
and
S.P. Hau-Riege, A. Barty, P.B. Mirkarimi, D.G. Stearns, H. Chapman, D. Sweeney, M. Clift, E. Gullikson, M-S.Yi "Defect repair for extreme ultraviolet lithography (EUVL) mask blanks" Proc SPIE Vol. 5037 331 - 338
⁵ Company prospectus of the company Molecular Imprints, Inc. 1807 West Braker Lane Bldg. C, Austin TX 78758 (www. molecular imprints.com)

### 5. Detailed description of preferred embodiments

In the following, preferred embodiments of the method according to the invention are explained. However, it is to be understood that the parameters indicated in the following are only preferred values so that deviations from those values may also lead to the success according to the invention.

Firstly, the method according the present invention is described on the basis of etching a chromium layer. However, the method can also advantageously be used for all other metals which may for example be used as strip conductors in semiconductor devices such as copper or aluminum, if their chemical properties allow the formation of metal oxygen halogen compounds.

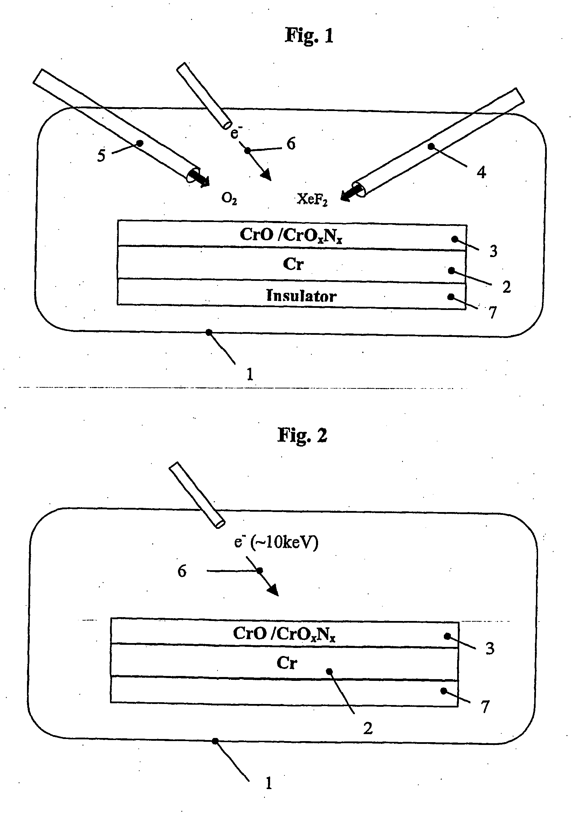

As schematically shown in Fig. 1, a chromium layer 2 to be etched is arranged within a vacuum chamber 1, for example an electron beam apparatus adapted for performing the method, such as an electron microscope. The vacuum should be sufficient so that the free mean path length of the electron reaches the sample. High vacuum conditions (< 10⁻⁶ mbar), however, are not necessary. The chromium layer 2 can be a mask for photolithography but also any other chromium layer, for example of a semiconductor device.

The chromium layer 2 is typically covered with a naturally formed oxide or, in case of a photo mask, with an approximately 40 nm thick CrO layer 3, which may in addition to oxygen also contain nitrogen. Masks for photolithography typically comprise a layer of chromium oxynitride as an anti-reflection coating. The chromium layer 2 itself typically contains small amounts of contaminations of carbon and possibly metals in low concentrations. The exact composition can be determined by known methods for surface analysis such as Auger electron spectroscopy (AES) or photoelectron spectroscopy (XPS).

Using the EBIE-method known from the prior art allows to etch the topmost CrO or CrOₓNₓ-layer 3 in the presence of XeF₂ with a low energy electron beam of 1 keV. However, the Cr layer 2 arranged therebelow could only be etched with higher electron energy. It is to be assumed that the essential etching process for the chromium in the prior art is a thermal evaporation due to the strong localized heating of the high energetic electron beam 6. However, this is not taught in the prior art of Russel et al..

In the present invention, as it is schematically shown in Fig. 1, an oxygen containing compound is therefore in addition to the etching gas XeF₂ introduced into the chamber 1. The oxygen containing compound is preferably molecular oxygen (O₂), water (H₂O) or hydrogen peroxide (H₂O₂). Other oxygen releasing compounds are also conceivable.

Both, the XeF₂ and the oxygen containing compound are supplied by suitable dosing valves and corresponding nozzles 4 or 5 onto the area of the chromium layer to be etched. Particularly preferred is the etching process, if the oxygen containing compound is dosed such that the oxygen and the halogen are present in a ratio of 1:100 to 1:10. This can easily be adjusted by using the dosing valve and the pressure adjustment in front of the nozzles, which determine the flow, and their geometry, wherein a mask spectrometer for analyzing the residual gas may additionally be used. Even lower doses of the oxygen containing compound in the range of < 1:100 may lead to a further improvement of the etching rate.

The dosage of the oxygen containing compound can either be simultaneous to the actual etching process or the CrOₓNₓ layer is at first etched, the Cr layer is subsequently oxidized at its surface by the oxygen containing compound in the vacuum chamber 1 which is followed by further etching etc.. In any case, the addition of the oxygen containing compound assures that sufficient oxygen is offered for the formation of the reaction products CrO₂F₂ and CrOF₂ which desorb from the surface. This method allows to etch for example the chromium layer of a photolithographic mask down to the substrate.

To achieve the etching, it is necessary to supply both etching gases with partial pressures measured in the chamber, which are at least 10 times or up to 150 times above the base pressure of the chamber of typically 10⁻⁶ mbar. In particular, it should be taken care that the gas supply provides at the location of the processing of the masks a local halogen gas pressure in the range of 10⁻⁵ mbar to 10⁻¹ mbar and a local oxygen gas pressure in the range of 10⁻⁷ mbar to 10⁻¹ mbar. This can be achieved by a particular throttling of the chamber gas or a low distance of the nozzles from the object.

In addition to balancing the chemical substances participating in the reaction the provision of the media from the gas supplying nozzle is taken into account by bombarding the layer to be etched with electrons in several repeated steps. However, refresh times are maintained before the beam returns to the previously processed spot to assure a complete coverage of the surface with new molecules from the gas supply, which are necessary for the reaction. The beams are either turned off or other spots are processed in between before the return to the initially processed spot. The time length for the beam to remain at one spot (the so-called "pixel dwell time") should be below 10⁻³ seconds and preferably below 10⁻⁵ speconds.

In contrast to methods known until now, the addition of oxygen allows to etch chromium layers already at low electron energies. Valves are below 5 keV, preferably at approximately 1 keV. Also the currents can be reduced so that typical values are below 400 pA, particularly preferred values are below 100 pA. A localized heating of the chromium layer 2 and the corresponding loss of spatial resolution during etching are not to be feared at these values. Also the condensation of the reaction molecules on the surface remains high, which is not the case at an elevated temperature.

The area to be etched is determined by the electron beam, which can be scanned over the chromium layer by known methods (for example the beam control of a scanning electron microscope). Thermal effects have only a secondary influence, if at all. As a result, the method according to the invention allows to etch chromium layers with a high rate and high resolution to modify the structure of a photolithographic mask.

The method can also be used with very low energy electrons, for example from a scanning tunneling microscope or another low energy electron source, since only energies > 2 eV are necessary for starting the chemical reaction of the oxidation or fluoration of the oxide.

Fig. 2 shows schematically the performance of a further example for the selective removal of material. In this case the surface to be processed is bombarded with a focused electron beam at an energy of preferably approximately 10 keV without adding any reaction gases. The currents of the electron beam are preferably between 0.1 nA and 1 µA. This allows to selectively create holes in a chromium oxide-chromium oxynitride layer and the chromium layer of a photolithography mask arranged therebelow. This is explained by the thermal evaporation of the material by the high energetic electron beam. The diameter of the beam is preferably between 0.1 µm and 0.5 µm.

The obtained material removal is determined by the current, the energy of the electron beam, its pulse length and by the thermal conductivity of the layer to be processed. An appropriate distribution of the dose rate provided by the electron beam allows furthermore to adapt the yield to the geometry of a defect of a mask or a semiconductor device to be processed.

The method can also be advantageously used for modifying circuits, i.e. circuit editing, wherein metal conductive strips are to be separated or to be reconnected inside the depth of a device. The electron beam enters preferably the depth of the device through the same opening which was at first opened by evaporation or chemical etching with support of the electron beam. Finally, this method can also be used for repairing arbitrary metal layers on substrates with poor thermal conductivity such as a next generation lithography NGL mask for deep UV, extreme UV (EUV), etc., which have the highest requirement to the spatial resolution.

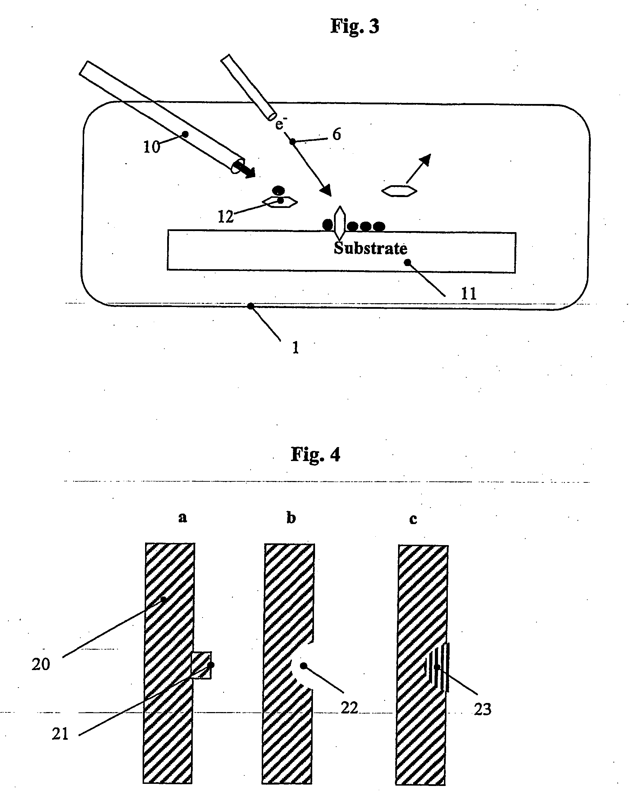

Fig. 3 illustrates a method for depositing metal layers with a high spatial resolution. To this end, a precursor gas 12 is at first introduced into the vacuum chamber via a nozzle 10. Suitable precursor gases are in particular metallo-organic compounds, for example cyclopentadienyl platinum dimethyl, which are deposited onto the substrate from the gas phase. If this condensate is subsequently selectively exposed to an electron beam⁶, the organic parts desorb and the remaining metal atoms form a conducting metal layer which can be used for repairing defects of a mask or a semiconductor device.
⁶ H.W.P. Koops, J. Kretz, M. Rudolph, M. Weber, G. Dahm. K.L. Lee, "Characterization and application of materials grown by electron beam induced deposition", Jpn. J. Appl. Phys Vol. 33 (1994) 7099-7107, Part. 1 No. 12B, December 1994

The electron beam, having in this method preferably an energy of 1 keV - 40 keV and a current in the region of 1 pA to 100 nA does not heat the sample. This applies up to currents below 1 nA. The improvement to the prior art is achieved by heating the substrate locally resolved to temperatures between 50°C and 100°C, preferably approx. 80°C by a suitable selection of the current and the electron energy as well as the focus, which causes a local desorption of the organic components of the precursor. This allows to produce purer substances with less contamination, which is relevant for the manufacture of well-conducting materials but also for highly insulating materials which may for example be deposited from TEOS (tetraethyl ortho siloxane) or other silanes by EBID (electron beam induced deposition). The localized heating of the substrate and the thermal control of the reaction leads to purer oxides. Both are necessary for circuit editing. The exact temperature, which may also be outside of the indicated range, depends on the organic compounds of the precursor substances 12 which are respectively to be dissolved and on the strength of their bond to the substrate. This method does not follow the approach to remove, with a high current, reaction products out of the substrate material and the absorbed precursor from the surface which were caused in a reaction by means of a heat supply from a broadly distributed electron beam, and to obtain their vaporization since otherwise they would remain on the surface, cf. the evaporation of chromyle chloride above 250°C.

This method does not require a complex mechanically unstable arrangement for a heated table to heat the overall substrate and allows for example with the help of a computer based prediction of the heating an exact control of the reaction (cf. the program "Temptation" of the company Soft Services, Castro Valley, CA, USA).

If the above explained methods are combined, defects 21 of a mask or a strip-conductor 20 of a semiconductor element as schematically shown in fig. 4A can be easily repaired by means of a focussed electron beam. To this end, material is at first removed from the strip conductor 20 by selective etching using the above-described method with a halogen compound and an oxygen containing compound at low electron currents or by a bombardment with high energetic electrons of a high current (high current process) in order to bring the defect 21 into a defined shape 22. In a further step (cf. fig. 4c), the above-explained method is subsequently used to selectively deposit at a comparatively low electron current (preferred values are 1 pA to 500 pA) opaque or transparent or electrically conducting material 23 in the region of the etched repair point 22, so that the desired shape of the strip conductor is restored.

Also the reversed sequence for processing a defect is conceivable wherein material is at first deposited using the explained high resolution deposition technique in the area of the defect and wherein subsequently any excessive material is etched in the described manner or vaporized by high energetic electron bombardment. In any case, the overall process can be performed in situ in a single vacuum chamber. Only the mentioned process gases have to be introduced and the parameters of the electron beam have to be adjusted in the indicated manner.

## Claims

1. Method for etching a metal and/or a metal oxide layer (2, 3) in a vacuum chamber (1), comprising the following method steps:
a. introducing a fluorine containing halogen compound (4) into the vacuum chamber (1);
b. introducing an oxygen containing compound (5) into the vacuum chamber (1);
c. directing an electron beam (6) having an energy of < 5 keV onto the area of the metal layer (2) to be etched.

2. Method according to claim 1, wherein the fluorine containing halogen compound and the oxygen containing compound are dosed such that the stoichiometric ratio of oxygen to halogen is between 1:1000 and 2:1.

3. Method according to claim 2, wherein the fluorine containing halogen compound and the oxygen containing compound are dosed such that the stoichiometric ratio of oxygen to halogen is between 1: 100 and 1:1.

4. Method according to claim 3, wherein the fluorine containing halogen compound and the oxygen containing compound are dosed such that the stoichiometric ratio of oxygen to halogen is essentially 1:10.

5. Method according to one of the claims 1 to 4, wherein the fluorine containing halogen compound and the oxygen containing compound are introduced into the vacuum chamber (1) one after the other.

6. Method according to one of the claims 1 to 4, wherein the fluorine containing halogen compound and the oxygen containing compound are essentially simultaneously introduced into the vacuum chamber (1).

7. Method according to one of the claims 1 to 6, wherein O₂, H₂O, or H₂O₂ or mixtures thereof are used as oxygen containing compound.

8. Method according to one of the claims 1 to 7, wherein the fluorine containing halogen compound comprises xenon or another noble gas.

9. Method according to one of the claims 1 - 8, wherein the fluorine containing halogen compound comprises XeF, XeF₂, XeF₄.

10. Method according to one of the claims 1 - 9, wherein the electron beam (6) has a current of < 400 pA.

11. Method according to claim 10, wherein the electron beam (6) comprises a current of < 100 pA.

12. Method according to one of the claims 1 - 11, wherein the electron beam (6) has an energy of between 2 eV and 2 keV.

13. Method according to one of the claims 1 - 12, wherein the refresh time of the electron beam is >= 1 msec

14. Method according to one of the claims 1-13, wherein the dwell time of the electron beam is between 10⁻⁸ and 10⁻³ sec.

15. Method according to one of the claims 1 - 14, wherein the dwell time of the electron beam is between 10⁻⁷ and 10⁻⁵ sec.

## Patentansprüche

1. Verfahren zum Ätzen einer Metall- und / oder einer Metalloxidschicht (2, 3) in einer Vakuumkammer (1), aufweisend folgende Verfahrensschritte:
a. Einleiten einer Fluor enthaltenden Halogen-Verbindung (4) in die Vakuumkammer (1);
b. Einleiten einer Sauerstoff enthaltenden Verbindung (5) in die Vakuumkammer (1);
c. Richten eines Elektronenstrahls (6), der eine Energie < 5 keV aufweist auf den zu ätzenden Bereich der Metallschicht(2).

2. Verfahren nach Anspruch 1, wobei die Fluor enthaltende Halogen-Verbindung und die Sauerstoff enthaltende Verbindung so dosiert werden, dass das stöchiometrische Verhältnis von Sauerstoff zu Halogen zwischen 1:1000 und 2:1 beträgt.

3. Verfahren nach Anspruch 2, wobei die Fluor enthaltende Halogen-Verbindung und die Sauerstoff enthaltende Verbindung so dosiert werden, dass das stöchiometrische Verhältnis von Sauerstoff zu Halogen zwischen 1:100 und 1:1 beträgt.

4. Verfahren nach Anspruch 3, wobei die Fluor enthaltende Halogen-Verbindung und die Sauerstoff enthaltende Verbindung so dosiert werden, dass das stöchiometrische Verhältnis von Sauerstoff zu Halogen im Wesentlichen 1:10 beträgt.

5. Verfahren nach einem der Ansprüche 1 - 4, wobei die Fluor enthaltende Halogen-Verbindung und die Sauerstoff enthaltende Verbindung nacheinander in die Vakuumkammer (1) eingeleitet werden.

6. Verfahren nach einem der Ansprüche 1 - 4, wobei die Fluor enthaltende Halogen-Verbindung und die Sauerstoff enthaltende Verbindung im Wesentlichen gleichzeitig in die Vakuumkammer (1) eingeleitet werden.

7. Verfahren nach einem der Ansprüche 1 - 6, wobei O₂, H₂O oder H₂O₂ oder Mischungen daraus als Sauerstoff enthaltende Verbindung eingesetzt wird.

8. Verfahren nach einem der Ansprüche 1 - 7, wobei die Fluor enthaltende Halogen-Verbindung Xenon oder ein anderes Edelgas umfasst.

9. Verfahren nach einem der Ansprüche 1 - 8, wobei die Fluor enthaltende Halogen-Verbindung XeF, XeF₂, XeF₄ aufweist.

10. Verfahren nach einem der Ansprüche 1 - 9, wobei der Elektronenstrahl (6) eine Stromstärke von < 400 pA aufweist.

11. Verfahren nach Anspruch 10, wobei der Elektronenstrahl (6) eine Stromstärke von < 100 pA aufweist.

12. Verfahren nach einem der Ansprüche 1 - 11, wobei der Elektronenstrahl (6) eine Energie zwischen 2 eV und 2 keV aufweist.

13. Verfahren nach einem der Ansprüche 1 - 12, wobei die refresh time des Elektronenstrahls ≥ 1 msec beträgt.

14. Verfahren nach einem der Ansprüche 1 - 13, wobei die dwell time des Elektronenstrahls zwischen 10⁻⁸ und 10⁻³ sec beträgt.

15. Verfahren nach einem der Ansprüche 1 - 14, wobei die dwell time des Elektronenstrahls zwischen 10⁻⁷ und 10⁻⁵ sec beträgt.

## Revendications

1. Procédé de gravure d'une couche (2, 3) de métal et/ou d'oxyde métallique dans une chambre à vide (1), comprenant les étapes de procédé suivantes :
a. introduction d'un composé halogéné contenant du fluor (4) dans la chambre à vide (1) ;
b. introduction d'un composé contenant de l'oxygène (5) dans la chambre à vide ;
c. envoi d'un faisceau d'électrons (6) présentant une énergie de < 5 keV sur la surface de la couche métallique (2) à graver.

2. Procédé selon la revendication 1, dans lequel le composé halogéné contenant du fluor et le composé contenant de l'oxygène sont dosés de sorte que le rapport stoechiométrique de l'oxygène à l'halogène soit compris entre 1:1000 et 2:1.

3. Procédé selon la revendication 2, dans lequel le composé halogéné contenant du fluor et le composé contenant de l'oxygène sont dosés de sorte que le rapport stoechiométrique de l'oxygène à l'halogène soit compris entre 1:100 et 1:1.

4. Procédé selon la revendication 3, dans lequel le composé halogéné contenant du fluor et le composé contenant de l'oxygène sont dosés de sorte que le rapport stoechiométrique de l'oxygène à l'halogène vaille essentiellement 1:10.

5. Procédé selon l'une des revendications 1 à 4, dans lequel le composé halogéné contenant du fluor et le composé contenant de l'oxygène sont introduits dans la chambre à vide (1) l'un après l'autre.

6. Procédé selon l'une des revendications 1 à 4, dans lequel le composé halogéné contenant du fluor et le composé contenant de l'oxygène sont introduits essentiellement simultanément dans la chambre à vide (1).

7. Procédé selon l'une des revendications 1 à 6, dans lequel O₂, H₂O ou H₂O₂ ou des mélanges de ceux-ci sont utilisés en tant que composé contenant de l'oxygène.

8. Procédé selon l'une des revendications 1 à 7, dans lequel le composé halogéné contenant du fluor comprend du xénon ou un autre gaz noble.

9. Procédé selon l'une des revendications 1 à 7, dans lequel le composé halogéné contenant du fluor comprend XeF, XeF₂, XeF₄.

10. Procédé selon l'une des revendications 1 à 9, dans lequel le faisceau d'électrons (6) présente un courant de < 400 pA.

11. Procédé selon la revendication 10, dans lequel le faisceau d'électrons (6) présente un courant de < 100 pA.

12. Procédé selon l'une des revendications 1 à 11, dans lequel le faisceau s'électrons (6) présente une énergie comprise entre 2 eV et 2 keV.

13. Procédé selon l'une des revendications 1 à 12, dans lequel le temps de rafraichissement du faisceau d'électrons est >= 1 ms.

14. Procédé selon l'une des revendications 1 à 13, dans lequel le temps de maintien du faisceau électronique est compris entre 10⁻⁸ et 10⁻³ s.

15. Procédé selon l'une des revendications 1 à 14, dans lequel le temps de maintien du faisceau électronique est compris entre 10⁻⁷ et 10⁻⁵ s.
